# EUROPEAN PATENT APPLICATION

(11) **EP 2 098 316 A2**
(43) Date of publication of application: **09.09.2009**
(21) Application number: 09153469.3
(22) Date of filing: 23.02.2009
(51) Int. Cl.: B22F 1/00, H01B 1/22, H01L 51/00

(54) **Metal nanoparticles stabilized with a bident amine**

(30) Priority: 26.02.2008 US 37321
(71) Applicant: Xerox Corporation, Rochester, New York 14644 (US)
(72) Inventor: Li, Yuning, 128044, Singapore (SG); Lee, Jonathan, Oakville Ontario L6H 4K4 (CA); Smith, Paul F., Oakville Ontario L6J 2G2 (CA); Mahabadi, Hadi K., Mississauga Ontario L5K 2L1 (CA)
(74) Representative: Jones, Helen M.M.

(57) **Abstract**

A metal nanoparticle composition includes a bident amine stabilizer associated with an external surface of the metal nanoparticle. A method of forming conductive features on a substrate, providing a solution of dispersed bident amine-stabilized metal nanoparticles, depositing the bident amine-stabilized metal nanoparticle dispersion onto a substrate, and heating the printed substrate to form conductive features on the surface of the substrate.

## Description

Fabrication of electronic circuit elements using liquid deposition techniques is of profound interest as such techniques provide potentially low-cost alternatives to conventional mainstream amorphous silicon technologies for electronic applications such as thin-film transistors (TFTs), light-emitting diodes (LEDs), RFID tags, photovoltaics, etc. However, the deposition and/or patterning of functional electrodes, pixel pads, and conductive traces, lines and tracks which meet the conductivity, processing, and cost requirements for practical applications have been a great challenge.

Previous approaches utilizing conjugated polymers such polyaniline, carbon black pastes and metal pastes were beset with low conductivity, poor operational stability and high costs. Another approach utilizing organoamine stabilized silver nanoparticles did achieve a lower annealing temperature, as described in U.S. Patent No. 7,270,694.

Silver nanoparticles have also been prepared, for example as described in U.S. Pub. No. 20070099357 A1, using 1) amine-stabilized silver nanoparticles and 2) exchanging the amine stabilizer with a carboxylic acid stabilizer. However, this method typically requires a carboxylic acid with a carbon chain length greater than 12 carbon atoms to afford sufficient solubility for solution-processing. Due to the high boiling point of such long-chain carboxylic acids and the strong bond between the carboxylic acid and silver nanoparticles, the annealing temperature required for obtaining conductive silver films is typically greater than 200 °C. Although some specialty plastic substrates can withstand annealing temperatures of 200 °C or more, most plastic substrates cannot. Low cost plastic substrates favor an annealing temperature below 150 °C.

Silver nanoparticles have additionally been prepared, for example as described in Manna et. al, "Formation of Silver Nanoparticles from a N-hexadecylethylenediamine Silver Nitrate Complex", using a bident amine (N-hexadecylethylenediamine) silver nitrate complex to form silver nanoparticles. However, this article only recites the use of one bident amine with 18 carbon atoms, N-hexadecylethylenediamine, and further does not recite the low annealing temperature, below 150 °C, that can be obtained from stabilizing a metal nanoparticle with a bident amine.

There is therefore a need, addressed by the subject matter disclosed herein, for a method of preparing stable metal nanoparticle compositions that 1) can be printed on a low cost plastic substrate and can be annealed at a temperature below at least about 150 °C and 2) possess a sufficient shelf time.

The above and other issues are addressed by the present application, wherein in embodiments, the application relates to metal nanoparticles having a bident amine stabilizer attached to the surface of the nanoparticles, and to methods of producing the same. The nanoparticles may be stabilized using a bident amine. The stabilized nanoparticles can be used to fabricate conductive elements having sufficiently high conductivity for electronic devices at a low temperature, for example, below about 200 °C, or below about 150 °C. The metal nanoparticles prepared in accordance with the present procedures possess, in embodiments, 1) good stability or shelf life and/or 2) low annealing temperatures, and may be made into metal nanoparticle compositions with suitable liquids for fabricating liquid-processed conductive elements for electronic devices.

Described is a bident amine-stabilized metal nanoparticle comprising a bident amine stabilizer associated with an external surface of the metal nanoparticle, wherein the bident amine in the bident amine stabilizer is represented by the formula: 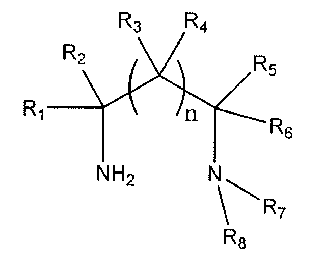 wherein n represents the number of repeating units of from about 0 to about 4, wherein R₁, R₂, R₃, R₄, R₅, R₆, R₇, and R₈ are side chains independently selected from the group consisting of a hydrogen atom, a hydrocarbon group having from 1 to about 15 carbon atoms, a heteroatom, and combinations thereof, and wherein at least one of R₁, R₂, R₃, R₄, R₅, R₆, R₇, and R₈ are not a hydrogen atom.

Also, described herein is a method for producing a bident amine-stabilized metal nanoparticle comprising: reducing a metal compound in the presence of a bident amine and a reducing agent to form metal nanoparticles having a bident amine stabilizer on the surface of the metal nanoparticle.

Still further described herein is a method for producing conductive features on a substrate comprising: providing a solution of dispersed metal nanoparticles, adding a bident amine to the solution of dispersed metal nanoparticles to form a bident amine-stabilized metal nanoparticle dispersion, depositing the bident amine-stabilized metal nanoparticle dispersion onto a substrate, and annealing the printed substrate to form conductive features on the surface of the substrate.

Thus, described herein is a metal nanoparticle stabilized with a bident amine associated with an external surface of the metal nanoparticle, a method for making conductive nanoparticles having a stabilizer on a surface thereof, and the formation of conductive features using such nanoparticles.

A method for producing the conductive nanoparticles may be done by the addition of a bident amine stabilizer to form metal nanoparticles with a bident amine stabilizer on the surface of the metal nanoparticles. The method may isolate the metal nanoparticles with the molecules of the stabilizer on the surface of the metal nanoparticles. The metal nanoparticles may thereafter be dispersed into a dispersion to form a stabilized dispersion comprised of metal nanoparticles with molecules of the bident amine stabilizer on the surface of the metal nanoparticles.

The term "nano" as used in "metal nanoparticles" refers to, for example, a particle size of less than about 1,000 nm, such as, for example, from about 0.5 nm to about 1,000 nm, for example, from 1 nm to about 500 nm, from 1 nm to about 100 nm, or from 1 nm to about 20 nm. The particle size refers to the average diameter of the metal particles, as determined by TEM (transmission electron microscopy) or other suitable method.

In embodiments, the metal nanoparticles are composed of (i) one or more metals or (ii) one or more metal composites. Suitable metals may include, for example, Ag, Au, Pt, Pd, Cu, Co, Cr, In, and Ni, particularly the transition metals, for example, Ag, Au, Pt, Pd, Cu, Cr, Ni, and mixtures thereof. Silver may be used as a particularly suitable metal. Suitable metal composites may include Au-Ag, Ag-Cu, Ag-Ni, Au-Ni, Au-Cu, Au-Ag-Cu, and Au-Ag-Pd. The metal composites may include non-metals, such as, for example, Si, C, and Ge. The various components of the silver composite may be present in an amount ranging for example from about 0.01% to about 99.9% by weight, particularly from about 10% to about 90% by weight. In embodiments, the metal composite is a metal alloy composed of silver and one, two or more other metals, with silver comprising for example at least about 20% of the nanoparticles by weight, particularly greater than about 50% of the nanoparticles by weight. Unless otherwise noted, the weight percentages recited herein for the components of the metal nanoparticles do not include the stabilizer.

The addition of a bident amine stabilizer to the metal nanoparticle forms metal nanoparticle having a bident amine stabilizer on the surface of the metal nanoparticle. The addition of the bident amine stabilizer isolates the metal nanoparticles with the molecules of the stabilizer on the surface of the metal nanoparticles and thus forms a bident amine-stabilized metal nanoparticle.

In embodiments, the bident amine-stabilized metal nanoparticle can be prepared directly by reducing a metal compound in the presence of a bident amine with a reducing agent. Examples of the metal compound may be selected from a group consisting of metal oxide, metal nitrate, metal nitrite, metal carboxylate, metal acetate, metal carbonate, metal perchlorate, metal sulfate, metal chloride, metal bromide, metal iodide, metal trifluoroacetate, metal phosphate, metal trifluoroacetate, metal benzoate, metal lactate and combinations thereof.

The reducing agent can be any compound that can reduce the metal compounds into elemental metals (metals with zero valence).

The reducing agent may be hydrazine (NH₂NH₂), including its hydrates and salts, and a hydrazine compound. As used herein, the term "hydrazine compound" refers to, for example, substituted hydrazines or their suitable hydrates or salts. The substituted hydrazine may contain from 1 carbon atom to about 30 carbon atoms, from 1 carbon atom to about 25 carbon atoms, from about 2 carbon atoms to about 20 carbon atoms and from about 2 carbon atoms to about 16 carbon atoms. In embodiments, the substituted hydrazine may include, for example, a hydrocarbyl hydrazine, a hydrazide, a carbazate and a sulfonohydrazide.

The use of a hydrazine compound as a reducing agent may have a number of advantages, such as, for example, 1) having solubility in water, polar or non-polar organic solvents depending on the substitution; 2) having strong to weak reducing ability depending on the substitution; and 3) nonexistence of non-volatile metal ions as in other reducing agents such as, for example, sodium hydroboride, which would facilitate the removal of by-product or unreacted reducing agent.

Examples of hydrocarbyl hydrazine include, for example, RNHNH₂, RNHNHR' and RR'NNH₂, where one nitrogen atom is mono- or di-substituted with R or R', and the other nitrogen atom is optionally mono- or di-substituted with R or R', where each R or R' is a hydrocarbon group. Examples of hydrocarbyl hydrazines include, for example, methylhydrazine, tert-butylhydrazine, 2-hydroxyethylhydrazine, benzylhydrazine, phenylhydrazine, tolylhydrazine, bromophenylhydrazine, chlorophenylhydrazine, nitrophenylhydrazine, 1,1-dimethylhydrazine, 1,1-diphenylhydrazine, 1,2-diethylhydrazine, and 1,2-diphenylhydrazine.

Unless otherwise indicated, in identifying the substituents for R and R' of the various reducing agents, the phrase "hydrocarbon group" encompasses both unsubstituted hydrocarbon groups and substituted hydrocarbon groups. Unsubstituted hydrocarbon groups may include any suitable substituent such as, for example, a hydrogen atom, a straight chain or branched alkyl group, a cycloalkyl group, an aryl group, an alkylaryl group, arylalkyl group or combinations thereof. Alkyl and cycloalkyl substituents may contain from about 1 to about 30 carbon atoms, from about 5 to 25 carbon atoms and from about 10 to 20 carbon atoms. Examples of alkyl and cycloalkyl substituents include, for example, methyl, ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, or eicosanyl, and combinations thereof. Aryl groups substituents may contain from about 6 to about 48 carbon atoms, from about 6 to about 36 carbon atoms, from about 6 to about 24 carbon atoms. Examples of aryl substituents include, for example, phenyl, methylphenyl (tolyl), ethylphenyl, propylphenyl, butylphenyl, pentylphenyl, hexylphenyl, heptylphenyl, octylphenyl, nonylphenyl, decylphenyl, undecylphenyl, dodecylphenyl, tridecylphenyl, tetradecylphenyl, pentadecylphenyl, hexadecylphenyl, heptadecylphenyl, octadecylphenyl, or combinations thereof. Substituted hydrocarbon groups may be the unsubstituted hydrocarbon groups described herein which are substituted with one, two or more times with, for example, a halogen (chlorine, fluorine, bromine and iodine), a nitro group, a cyano group, an alkoxy group (methoxyl, ethoxyl and propoxy), or heteroaryls. Examples of heteroaryls groups may include thienyl, furanyl, pyridinyl, oxazoyl, pyrroyl, triazinyl, imidazoyl, pyrimidinyl, pyrazinyl, oxadiazoyl, pyrazoyl, triazoyl, thiazoyl, thiadiazoyl, quinolinyl, quinazolinyl, naphthyridinyl, carbazoyl, or combinations thereof.

Examples of hydrazine compounds may include, for example, hydrazides, RC(O)NHNH₂ and RC(O)NHNHR' and RC(O)NHNHC(O)R, where one or both nitrogen atoms are substituted by an acyl group of formula RC(O), where each R is independently selected from hydrogen and a hydrocarbon group, and one or both nitrogen atoms are optionally mono- or di-substituted with R', where each R' is independently selected from hydrogen or a hydrocarbon group. Examples of hydrazide may include, for example, formic hydrazide, acethydrazide, benzhydrazide, adipic acid dihydrazide, carbohydrazide, butanohydrazide, hexanoic hydrazide, octanoic hydrazide, oxamic acid hydrazide, maleic hydrazide, N-methylhydrazinecarboxamide, and semicarbazide.

Examples of hydrazine compounds may include, for example, carbazates and hydrazinocarboxylates, for example, ROC(O)NHNHR', ROC(O)NHNH₂ and ROC(O)NHNHC(O)OR, where one or both nitrogen atoms are substituted by an ester group of formula ROC(O), where each R is independently selected from hydrogen and a hydrocarbon group, and one or both nitrogen atoms are optionally mono- or di-substituted with R', each R' is independently selected from hydrogen or a hydrocarbon group. Examples of carbazate may include, for example, methyl carbazate (methyl hydrazinocarboxylate), ethyl carbazate, butyl carbazate, benzyl carbazate, and 2-hydroxyethyl carbazate.

Examples of sulfonohydrazides include, for example, RSO₂NHNH₂, RSO₂NHNHR', and RSO₂NHNHSO₂R, where one or both nitrogen atoms are substituted by a sulfonyl group of formula RSO₂, where each R is independently selected from hydrogen and a hydrocarbon group, and one or both nitrogen atoms are optionally mono- or di-substituted with R', where each R' is independently selected from hydrogen or a hydrocarbon group. Examples of sulfonohydrazide may include, for example, methanesulfonohydrazide, benzenesulfonohydrazine, 2,4,6-trimethylbenzenesulfonohydrazide, and p-toluenesulfonohydrazide.

Other hydrazine compounds may include, for example, aminoguanidine, thiosemicarbazide, methyl hydrazinecarbimidothiolate, and thiocarbohydrazide.

The reducing agent may also be a metal hydride. A metal hydride is comprised of one or more metals in a hydride group. Examples of the metal hydride may include, for example, NaBH₄, LiBH₄, KBH₄, NaAlH₄, LiAlH₄, CaH₂ and combinations thereof. Another example of the metal hydride may include borane (BH₃) complexes such as, for example, borane-N,N-tert-butylamine complex, borane-N,N-diisopropylethylamine complex, borane-dimethylamine complex, borane-pyridine complex, borane-tetrahydrofuran complex, borane-triethylamine complex, borane-triphenylphosphine complex, and combinations thereof.

The reducing agent may also be a tin (II) compound or a tin (II) compound hydrate. Example of the tin (II) compound such as, for example, tin (II) chloride, tin (II) bromide, tin (II) iodide, tin (II) acetate, tin (II) 2-ethylhexanoate, tin (II) palmitate, tin (II) stearate, tin (II) oxalate, tin (II) sulfate, tin (II) sulfide, and combinations thereof.

The reducing agent may also be a polyol represented by the formula CH₂OH(CHOH)ₙCH₂OH, where n is the number of repeating units from 1 to about 10, such as from 1 to about 8, from 1 to about 5 or from about 2 to about 4. Example polyols may include, for example, ethylene glycol, glycerol, propylene glycol diethylene glycol or mixtures thereof.

The reducing agent may also be an aldehyde represented by the formula RCHO, characterized by the unsaturated carbonyl group (C=O), wherein R is selected to be a hydrogen atom or a hydrocarbon group comprised of from 1 to about 20 carbon atoms, from 1 to about 12 carbon atoms, from 1 to about 8 carbon atoms and from about 2 to about 5 carbon atoms. Examples of aldehydes may include, for example, methanal, ethanal, propanal, butanal, hexanal, 4-chlorobutanal, propynal, 3-oxobutanal, and combinations thereof.

The reducing agent may also be a ketone represented by the formula RCOR', characterized by the saturated carbonyl group (C=O), wherein R is selected to be a hydrogen atom or a hydrocarbon group comprised of from 1 to about 20 carbon atoms, from 1 to about 12 carbon atoms, from 1 to about 8 carbon atoms and from about 2 to about 5 carbon atoms and R' is selected to be a hydrogen atom or a hydrocarbon group comprised of from 1 to about 20 carbon atoms, from 1 to about 12 carbon atoms, from 1 to about 8 carbon atoms and from about 2 to about 5 carbon atoms. The carbonyl group can be placed at any suitable carbon atom in the carbon chain. Examples of ketones may include, for example, acetone, ethyl methyl ketone, diethyl ketone, benzophenone, 2-pentanone, 4-chloro-6-methyl-3-heptanone, and combinations thereof.

In embodiments, the reducing agent is one component of a reducing agent solution. Any suitable liquid or solvent may be used for the reducing agent solution, including, for example, organic solvents and water. The liquid organic solvent may comprise, for example, an alcohol such as methanol, ethanol, propanol, butanol, pentanol, hexanol, heptanol, octanol, a hydrocarbon solvent such as pentane, hexane, cyclohexane, heptane, octane, nonane, decane, undecane, dodecane, tridecane, tetradecane, toluene, xylene, mesitylene, tetrahydrofuran; chlorobenzene; dichlorobenzene; trichlorobenzene; nitrobenzene; cyanobenzene; acetonitrile; alcohols, or combinations thereof.

The weight percentage of solvent in the reducing agent solution is, for example, from about 0 weight percent to about 95 weight percent, from about 20 weight percent to about 80 weight percent or from about 30 weight percent to about 60 weight percent of the total solution weight. The concentration of the hydrazine compound in the reducing agent solution may be, for example, from about 1 weight percent to about 100 weight percent, from about 5 weight percent to about 80 weight percent, from about 10 weight percent to about 60 weight percent, or from about 15 weight percent to about 50 weight percent, of the solution.

One, two, three or more solvents may be used in the reducing agent solution. In embodiments where two or more solvents are used, each solvent may be present at any suitable volume ratio or weight ratio such as, for example, from about 99(first solvent):1(second solvent) to about 1(first solvent):99(second solvent).

One, two, three or more reducing agents may be used. In embodiments where two or more reducing agents are used, each reducing agent may be present at any suitable weight ratio or molar ratio such as, for example, from about 99(first reducing agent):1(second reducing agent) to about 1(first reducing agent):99(second reducing agent).

In embodiments, to achieve both a good solubility and annealing temperature below at least 150 °C, the bident amine may be comprised of from about 4 to about 16 carbon atoms, from about 6 to about 16 carbon atoms, from about 8 to about 16 carbon atoms.

In embodiments, the bident amine stabilizer may be represented by formula (1) 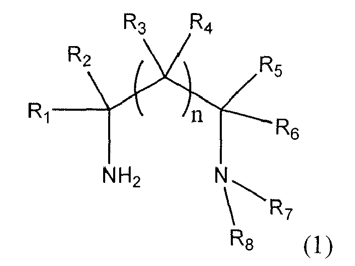 wherein n represents the number of repeating units of from 0 to about 4 and from 0 to about 2, and wherein R₁, R₂, R₃, R₄, R₅, R₆, R₇, and R₈ are side chains independently selected from the group consisting of a hydrogen atom, a hydrocarbon group having from 1 to about 15 carbon atoms, from 1 to about 12 carbon atoms and from about 2 to about 10 carbon atoms, a heteroatom, and combinations thereof.

Unless otherwise indicated, in identifying the substituents for R₁, R₂, R₃, R₄, R₅, R₆, R₇, and R₈ the phrase "hydrocarbon group" encompasses both unsubstituted hydrocarbon groups and substituted hydrocarbon groups. The unsubstituted hydrocarbon group may contain, for example, from 1 to about 15 carbon atoms, from 1 to about 12 carbon atoms or from about 2 to about 10 carbon atoms. Examples of the unsubstituted hydrocarbon groups may include, for example, a straight chain alkyl group, a branched alkyl group, a cycloalkyl group, an aryl group, an alkylaryl group, and an arylalkyl group having the above carbon atom amounts. Example alkyl groups may include, for example, methyl, ethyl, propyl, butyl, pentyl, hexyl, heptyl, octyl, nonyl, decyl, undecyl, dodecyl, tridecyl, tetradecyl, pentadecyl, and isomeric forms thereof.

The substituted hydrocarbon group may contain, for example, from 1 to about 15 carbon atoms, from 1 to about 12 carbon atoms or from about 2 to about 10 carbon atoms substituted with, for example, fluorine, bromine, chlorine, iodine, sulfur, amino, nitro, cyano, methoxyl, ethoxyl, propoxy, or combinations thereof. Substituted hydrocarbon groups may be, for example, a straight chain alkyl group, a branched alkyl group, a cycloalkyl group, an aryl group, an alkylaryl group, and an arylalkyl group with a heteroatom. Example alkyl groups may include, for example, methyl, ethyl, propyl, butyl, pentyl, hexyl, heptyl, octyl, nonyl, decyl, undecyl, dodecyl, tridecyl, tetradecyl, pentadecyl, and isomeric forms thereof. In embodiments, the hydrocarbon group may be optionally substituted alkyl and optionally substituted aryl.

Unless otherwise indicated, in identifying the substituents for R₁, R₂, R₃, R₄, R₅, R₆, R₇, and R₈ the term "heteroatom" includes fluorine, bromine, chlorine, iodine, sulfur, nitrogen, oxygen, or combinations thereof.

Examples of suitable bident amines include N,N-dipropylethylenediamine, N,N-dibutylethylenediamine, N,N-dipentylethylenediamine, N,N-dihexylethylenediamine, N,N-diheptylethylenediamine, N-N-dibutylaminopropylamine, N,N-dipentylaminopropylamine, N-N-dihexylaminopropylamine, N-N-diheptylaminopropylamine, N,N-diethyl-1,4-butanediamine, N,N-dipropyl-1,4-butanediamine, N,N-dibutyl-1,4-butanediamine, N,N-dipentyl-1,4-butanediamine, N,N-dihexyl-1,4-butanediamine, N-butylethylenediamine, N-pentylethylenediamine, N-hexylethylenediamine, N-heptylethylenediamine, N-octylethylenediamine, N-nonylethylenediamine, N-decylethylenediamine, N-dodecylethylenediamine, N-undecylethylenediamine, N-tridecylethylenediamine, N-tetradecylethylenediamine, N-pentadecylethylenediamine, N-propyl-1,3-propanediamine, N-butyl-1,3-propanediamine, N-pentyl-1,3-propanediamine, N-hexyl-1,3-propanediamine, N-heptyl-1,3-propanediamine, N-octyl-1,3-propanediamine, N-nonyl-1,3-propanediamine, N-decyl-1,3-propanediamine, N-undecyl-1,3-propanediamine, N-dodecyl-1,3-propanediamine, N-tridecyl-1,3-propanediamine, N-tetradecyl-1,3-propanediamine, N-propyl-1,4-butanediamine, N-butyl-1,4-butanediamine, N-pentyl-1,4-butanediamine, N-hexyl-1,4-butanediamine, N-heptyl-1,4-butanediamine, N-octyl-1,4-butanediamine, N-nonyl-1,4-butanediamine, N-decyl-1,4-butanediamine, N-undecyl-1,4-butanediamine, N-dodecyl-1,4-butanediamine, N-tridecyl-1,4-butanediamine, or combinations thereof.

The bident amine stabilizer may be formed on the surface of the nanoparticles by dissolving the metal compound and the bident amine into a first solvent. The resulting solution may be optionally heated to a temperature, for example, from about 35 °C to about 150 °C, from about 40 °C to about 100 °C or from about 45 °C to about 80 °C, to increase the rate of dissolution.

Upon the addition of a reducing agent such as phenylhydrazine, in an optional second solvent, the resulting reaction mixture may be stirred, for example, from about one minute to about two hours, from about fifteen minutes to about one hour or from about twenty minutes to about forty minutes, and optionally heated to a temperature, for example, from about 35 °C to about 150 °C, from about 40 °C to about 100 °C or from about 45 °C to about 80 °C, thereby forming the metal nanoparticles with the bident amine stabilizer on the surface of the metal nanoparticles. After optionally cooling the solution of metal nanoparticles containing the bident amine stabilizer to room temperature, the metal nanoparticles may be collected from the solution by any suitable method. In one example, the nanoparticles may be collected by being precipitated from the solution by the use of a third solvent.

Any suitable solvent can be used for the first and second solvents, including, for example, organic solvents and/or water. The organic solvents include, for example, hydrocarbon solvents such as pentane, hexane, cyclohexane, heptane, octane, nonane, decane, undecane, dodecane, tridecane, tetradecane, toluene, xylene, mesitylene, and the like; alcohols such as methanol, ethanol, propanol, butanol, pentanol and the like; tetrahydrofuran; chlorobenzene; dichlorobenzene; trichlorobenzene; nitrobenzene; cyanobenzene; acetonitrile; dichloromethane; N,N-dimethylformamide (DMF); and mixtures thereof. One, two, three or more solvents may be used. In embodiments where two or more solvents are used, each solvent may be present at any suitable volume ratio or molar ratio such as for example from about 99(first solvent): (second solvent) to about 1 (first solvent):99(second solvent).

Any suitable solvent can be used for the third solvent, which is non-solvent for the metal nanoparticles, that is, the metal nanoparticles are not soluble in the third solvent. Examples may include any of the solvents detailed above including liquids that are mixable with the solvents which are used to disperse/solubilize the metal nanoparticles, but are non-solvents for the metal nanoparticles. Whether a particular liquid is considered a solvent or non-solvent can change depending on a number of factors including, for example, the polarity of the stabilizer and the size of the metal nanoparticles. In embodiments where two or more solvents are used, each solvent may be present at any suitable volume ratio or molar ratio such as, for example, from about 99(first solvent):1 (second solvent) to about 1 (first solvent):99(second solvent).

In embodiments, the bident amine-stabilized metal nanoparticle can also be prepared by adding a bident amine into a monoamine-stabilized metal nanoparticle dispersion. The bident amine has a stronger bonding force with metal nanoparticle than the monoamine because the bident amine, with at least two nitrogen atoms, has a stronger electron donating/accepting effect. Thus, the bident amine can displace the monoamine from the surface of the metal nanoparticle and restabilize the metal nanoparticle.

The dispersion of monoamine-stabilized metal nanoparticles can be prepared by any suitable process including a chemical reduction process using a reducing agent, vacuum evaporation of metal, or sputtering of metals.

The monoamine in the monoamine-stabilized metal nanoparticle dispersion may be comprised of from about 8 to about 17 carbon atoms, from about 9 to about 16 carbon atoms and from about 12 to about 15 carbon atoms. Suitable examples of the monoamine may include octylamine, nonylamine, decylamine, undecylamine, dodecylamine, tridecylamine, tetradecylamine, hexadecylamine, heptadecylamine or combinations thereof.

A variety of bident amine stabilizers may be used which have the function of minimizing or preventing the metal nanoparticles from aggregation in a liquid and optionally providing the solubility or dispersibility of metal nanoparticles in a liquid. In addition, the bident amine stabilizer is connected to the surface of the metal nanoparticles and is not removed until the annealing of the metal nanoparticles during formation of metal features on a substrate.

In embodiments, the bident amine stabilizer is physically or chemically associated with the surface of the metal nanoparticles. In this way, the nanoparticles have the stabilizer thereon outside of a liquid system. That is, the nanoparticles with the stabilizer thereon, may be isolated and recovered from the reaction mixture solution used in forming the nanoparticles. The stabilized nanoparticles may thus be subsequently readily and homogeneously dispersed in a liquid system for forming a liquid processable dispersion.

As used herein, the phrase "physically or chemically associated" between the metal nanoparticles and the stabilizer can be a chemical bond and/or other physical attachment. The chemical bond can take the form of, for example, covalent bonding, hydrogen bonding, coordination complex bonding, or ionic bonding, or a mixture of different chemical bonds. The physical attachment can take the form of, for example, van der Waals' forces or dipole-dipole interaction, or a mixture of different physical attachments.

In embodiments, other organic stabilizers may be used in addition to the bident amine stabilizer. The term "organic" in "organic stabilizer" refers to, for example, the presence of carbon atom(s), but the organic stabilizer may include one or more non-metal heteroatoms such as nitrogen, oxygen, sulfur, silicon, halogen, and the like. Examples of other organic stabilizers may include, for example, thiol and its derivatives, -OC(=S)SH (xanthic acid), polyethylene glycols, polyvinylpyridine, polyninylpyrolidone, and other organic surfactants. The organic stabilizer may be selected from the group consisting of a thiol such as, for example, butanethiol, pentanethiol, hexanethiol, heptanethiol, octanethiol, decanethiol, and dodecanethiol; a dithiol such as, for example, 1,2-ethanedithiol, 1,3-propanedithiol, and 1,4-butanedithiol; or a mixture of a thiol and a dithiol. The organic stabilizer may be selected from the group consisting of a xanthic acid such as, for example, O-methylxanthate, O-ethylxanthate, O-propylxanthic acid, O-butylxanthic acid, O-pentylxanthic acid, O-hexylxanthic acid, O-heptylxanthic acid, O-octylxanthic acid, O-nonylxanthic acid, O-decylxanthic acid, O-undecylxanthic acid, O-dodecylxanthic acid. Organic stabilizers containing a pyridine derivative (for example, dodecyl pyridine) and/or organophosphine that can stabilize metal nanoparticles can also be used as a potential stabilizer.

One, two, three or more additional stabilizers other than a bident amine may be used during the synthesis of the metal nanoparticles. In embodiments where one, two or more additional stabilizers are used, the additional stabilizer(s) other than a bident amine may be present at any suitable weight ratio against bident amine such as, for example, from about 99(additional stabilizer(s)):1(bident amine) to about 1 (additional stabilizer(s)):99(bident amine).

The extent of the coverage of stabilizer on the surface of the metal nanoparticles can vary, for example, from partial to full coverage depending on the capability of the stabilizer to stabilize the metal nanoparticles. Of course, there is variability as well in the extent of coverage of the stabilizer among the individual metal nanoparticles.

The bident amine-stabilized metal nanoparticles may be dispersed in any suitable dispersing solvent to form a bident amine-stabilized metal nanoparticle dispersion that may be used for liquid deposition to form conductive features on a substrate. The weight percentage of the bident amine-stabilized metal nanoparticles dispersion may be, for example, from about 5 weight percent to about 80 weight percent, from about 10 weight percent to about 60 weight percent or from about 15 weight percent to about 50 weight percent. Examples of the dispersing solvent may include, for example, water, pentane, hexane, cyclohexane, heptane, octane, nonane, decane, undecane, dodecane, tridecane, tetradecane, toluene, xylene, mesitylene, and the like; alcohols such as, for example, methanol, ethanol, propanol, butanol, pentanol, hexanol, heptanol, octanol, and the like; tetrahydrofuran; chlorobenzene; dichlorobenzene; trichlorobenzene; nitrobenzene; cyanobenzene; acetonitrile; dichloromethane; N,N-dimethylformamide (DMF); and mixtures thereof. One, two, three or more solvents may be used. In embodiments where two or more solvents are used, each solvent may be present at any suitable volume ratio or molar ratio such as for example from about 99(first solvent):1(second solvent) to about 1 (first solvent):99(second solvent).

The fabrication of an electrically conductive element from the bident amine-stabilized metal nanoparticle dispersion can be carried out by depositing the composition on a substrate using a liquid deposition technique at any suitable time prior to or subsequent to the formation of other optional layer or layers on the substrate. Thus, liquid deposition of the composition on the substrate can occur either on a substrate or on a substrate already containing layered material, for example, a semiconductor layer and/or an insulating layer.

The phrase "liquid deposition technique" refers to, for example, deposition of a composition using a liquid process such as liquid coating or printing, where the liquid is a homogeneous or heterogeneous dispersion of the bident amine-stabilized metal nanoparticles. The metal nanoparticle composition may be referred to as an ink when printing is used. Examples of liquid coating processes may include, for example, spin coating, blade coating, rod coating, dip coating, and the like. Examples of printing techniques may include, for example, lithography or offset printing, gravure, flexography, screen printing, stencil printing, inkjet printing, stamping (such as microcontact printing), and the like. Liquid deposition deposits a layer of the composition having a thickness ranging from about 5 nanometers to about 5 millimeters, preferably from about 10 nanometers to about 1000 micrometers. The deposited metal nanoparticle composition at this stage may or may not exhibit appreciable electrical conductivity.

The stabilized metal nanoparticles can be spin-coated from the bident amine-stabilized metal nanoparticles dispersion, for example, for about 10 seconds to about 1000 seconds, for about 50 seconds to about 500 seconds or from about 100 seconds to about 150 seconds, onto a substrate at a speed, for example, from about 100 revolutions per minute ("rpm") to about 5000 rpm, from about 500 rpm to about 3000 rpm and from about 500 rpm to about 2000 rpm.

The substrate may be composed of, for example, silicon, glass plate, plastic film or sheet. For structurally flexible devices, plastic substrate, such as, for example, polyester, polycarbonate, polyimide sheets and the like may be used. The thickness of the substrate may be from amount 10 micrometers to about 10 millimeters, from about 50 micrometers to about 2 millimeters, especially for a flexible plastic substrate and from about 0.4 millimeters to about 10 millimeters for a rigid substrate such as glass or silicon.

Heating the deposited composition at a temperature of, for example, at or below about 150 °C, induces the metal nanoparticles to form an electrically conductive layer, which is suitable for use as an electrically conductive element in electronic devices. The heating temperature is one that does not cause adverse changes in the properties of previously deposited layer(s) or the substrate (whether single layer substrate or multilayer substrate). Also, the low heating temperatures described above allows the use of low cost plastic substrates, which have an annealing temperature below 150 °C.

The heating can be performed for a time ranging from, for example, 1 second to about 10 hours and from about 10 seconds to 1 hour. The heating can be performed in air, in an inert atmosphere, for example, under nitrogen or argon, or in a reducing atmosphere, for example, under nitrogen containing from 1 to about 20 percent by volume hydrogen. The heating can also be performed under normal atmospheric pressure or at a reduced pressure of, for example, from about 1000 mbars to about 0.01 mbars.

As used herein, the term "heating" encompasses any technique(s) that can impart sufficient energy to the heated material or substrate to cause the desired result such as thermal heating (for example, a hot plate, an oven, and a burner), infra-red ("IR") radiation, a laser beam, microwave radiation, or UV radiation, or a combination thereof.

Heating produces a number of effects. Prior to heating, the layer of the deposited metal nanoparticles may be electrically insulating or with very low electrical conductivity, but heating results in an electrically conductive layer composed of annealed metal nanoparticles, which increases the conductivity. In embodiments, the annealed metal nanoparticles may be coalesced or partially coalesced metal nanoparticles. In embodiments, it may be possible that in the annealed metal nanoparticles, the metal nanoparticles achieve sufficient particle-to-particle contact to form the electrically conductive layer without coalescence.

In embodiments, after heating, the resulting electrically conductive layer has a thickness ranging, for example, from about 5 nanometers to about 5 microns and from about 10 nanometers to about 2 microns.

The conductivity of the resulting metal element produced by heating the deposited metal nanoparticle composition is, for example, more than about 100 Siemens/centimeter ("S/cm"), more than about 1000 S/cm, more than about 2,000 S/cm, more than about 5,000 S/cm, or more than about 10,000 S/cm.

The resulting conductive elements can be used as electrodes, conductive pads, thin-film transistors, conductive lines, conductive tracks, and the like in electronic devices such as thin-film transistors, organic light emitting diodes, RFID (radio frequency identification) tags, photovoltaic, and other electronic devices which require conductive elements or components.

In yet other embodiments, there is provided a thin film transistor comprising:
(a) an dielectric layer;
(b) a gate electrode;
(c) a semiconductor layer;
(d) a source electrode;
(e) a drain electrode, and
(f) a substrate
wherein the dielectric layer, the gate electrode, the semiconductor layer, the source electrode, the drain electrode and the substrate are in any sequence as long as the gate electrode and the semiconductor layer both contact the insulating dielectric layer, and the source electrode and the drain electrode both contact the semiconductor layer, and, the semiconductor layer is comprised of an organic, inorganic, or an organic/inorganic hybrid semiconductor compound.

In embodiments and with further reference to the present disclosure, the substrate layer may generally be a silicon material inclusive of various appropriate forms of silicon, a metal film or sheet, a glass plate, a plastic film or a sheet, a paper, a fabric, and the like depending on the intended applications. For structurally flexible devices, a metal film or sheet such as, for example, aluminum, a plastic substrate, such as, for example, polyester, polycarbonate, polyimide sheets, and the like, may be selected. The thickness of the substrate may be, for example, from about 10 micrometers to over 10 millimeters with a specific thickness being from about 50 micrometers to about 10 millimeters, especially for a flexible plastic substrate, and from about 0.5 to about 10 millimeters.

The insulating dielectric layer, which can separate the gate electrode from the source and drain electrodes, and in contact with the semiconductor layer, can generally be an inorganic material film, an organic polymer film, or an organicinorganic composite film. Examples of inorganic materials suitable as the dielectric layer may include silicon oxide, silicon nitride, aluminum oxide, barium titanate, barium zirconate titanate, and the like. Examples of organic polymers for the dielectric layer may include polyesters, polycarbonates, poly(vinyl phenol), polyimides, polystyrene, poly(methacrylate)s, poly(acrylate)s, epoxy resin, and the like. Examples of inorganic-organic composite materials may include spin-on glass such as pMSSQ (polymethylsilsesquioxane), metal oxide nanoparticles dispersed in polymers, such as polyester, polyimide, epoxy resin, and the like. The thickness of the dielectric layer can be, for example, from 1 nanometer to about 5 micrometers with a more specific thickness being about 10 nanometers to about 1000 nanometers. More specifically, the dielectric material has a dielectric constant of, for example, at least about 3, thus a suitable dielectric thickness of about 300 nanometers can provide a desirable capacitance, for example, of about 10⁻⁹ to about 10⁻⁷ F/cm².

Situated, for example, between and in contact with the dielectric layer and the source/drain electrodes is the active semiconductor layer comprised of semiconductors, and wherein the thickness of this layer is generally, for example, about 10 nanometers to about 1 micrometer, or about 40 to about 100 nanometers. This layer can generally be fabricated by solution processes such as spin coating, casting, screen, stamp, or jet printing of a solution of semiconductors.

The gate electrode can be a thin metal film, a conducting polymer film, a conducting film generated from a conducting ink or paste, or the substrate itself (for example heavily doped silicon). Examples of the gate electrode materials may include gold, chromium, indium tin oxide, conducting polymers, such as polystyrene sulfonate-doped poly(3,4-ethylenedioxythiophene) (PSS/PEDOT), a conducting ink/paste comprised of carbon black/graphite or colloidal silver dispersion contained in a polymer binder, such as Electrodag available from Acheson Colloids Company, and silver filled electrically conductive thermoplastic ink available from Noelle Industries, and the like. The gate layer may be prepared by vacuum evaporation, sputtering of metals or conductive metal oxides, coating from conducting polymer solutions or conducting inks, or dispersions by spin coating, casting or printing. The thickness of the gate electrode layer may be, for example, from about 10 nanometers to about 10 micrometers, and a specific thickness is, for example, from about 10 to about 1000 nanometers for metal films, and about 100 nanometers to about 10 micrometers for polymer conductors.

The source and drain electrode layer can be fabricated from materials which provide a low resistance ohmic contact to the semiconductor layer. Typical materials suitable for use as source and drain electrodes may include those of the gate electrode materials such as silver, gold, nickel, aluminum, platinum, conducting polymers, and conducting inks. Typical thickness of this layer may be, for example, from about 40 nanometers to 1 micrometer with the more specific thickness being about 100 to about 400 nanometers. The TFT devices contain a semiconductor channel with a width W and length L. The semiconductor channel width may be, for example, from about 10 micrometers to about 5 millimeters with a specific channel width being about 100 micrometers to 1 millimeter. The semiconductor channel length may be, for example, from 1 micrometer to 1 millimeter with a more specific channel length being from about 5 micrometers to about 100 micrometers.

In embodiments, at least one of the gate, source or drain electrode in a thin-film transistor is formed by using a method described herein to form conductive features on a substrate, the method comprising: providing a solution of dispersed metal nanoparticles, adding a bident amine to the solution of dispersed metal nanoparticles to form a bident amine-stabilized metal nanoparticle dispersion, depositing the bident amine-stabilized metal nanoparticle dispersion onto a substrate, and annealing the printed substrate to form conductive features on the surface of the substrate.

The embodiments disclosed herein will now be described in detail with respect to specific exemplary embodiments thereof, it being understood that these examples are intended to be illustrative only and the embodiments disclosed herein is not intended to be limited to the materials, conditions, or process parameters recited herein. All percentages and parts are by weight unless otherwise indicated. Room temperature refers to a temperature ranging for example from about 20 to about 25°C.

### EXAMPLE 1

Silver acetate (1.67 grams, 10 mmol) and 1-dodecylamine (4.63 grams, 25 mmol) were dissolved in 20 mL of toluene and stirred at 55 °C for about 2 to 5 minutes until the silver acetate fully dissolved. A phenylhydrazine (0.6 grams, 5.5 mmol) solution in 5 mL of toluene was added to the above solution drop-wise and vigorously stirred until a dark red-brown color resulted. After the resulting solution was stirred at 55°C for 5 additional minutes, cooled to room temperature and added dropwise to mixture of acetone/methanol (150 mL/150 mL), a precipitate was formed. The precipitate (Yield: 1.33 grams) was subsequently filtered, washed briefly with acetone and methanol, dried in air and placed in a flask.

To the above flask, 1.33 grams of 3-dibutylaminopropylamine and 6.21 grams of toluene were added to form a dispersion containing 15 weight percent silver nanoparticles and 15 weight percent of 3-dibutylaminopropylamine. The mixture was shaken for 5 minutes to dissolve the solid and then filtered using a 0.4 micron syringe filter to give a dark brown dispersion.

The dark brown dispersion was spin coated on glass slides at 1000 rpm for 2 minutes to give brown thin films of silver nanoparticles and subsequently heated on a hot plate at 120°C for 20 minutes to a shiny mirror-like thin film with a thickness of approximately 110 nm. The conductivity of the thin film was between 1 - 3.5 × 10⁴ S/cm and measured using a conventional four-probe technique. The dispersion of silver nanoparticles that was created by the above method was stable at room temperature for over 30 days.

### EXAMPLE 2

Silver acetate (1.67 grams, 10 mmol) and 1-hexadecylamine (6.04 grams, 25 mmol) were dissolved in 20 mL of toluene and stirred at 60 °C for about 2 to 5 minutes until the silver acetate fully dissolved. A phenylhydrazine (0.6 grams, 5.5 mmol) solution in toluene (5 mL) was added to the above solution drop-wise and vigorously stirred until a dark red-brown color resulted. After the resulting solution was stirred at 60 °C for 5 additional minutes, cooled to room temperature and added dropwise to mixture of acetone/methanol (150 mL/150 mL), a precipitate was formed. The precipitate (yield: 1.44 grams) was subsequently filtered, washed briefly with acetone and methanol, dried in air and placed in a flask.

To the above flask, 0.96 grams of 3-dibutylaminopropylamine and 7.20 grams of toluene were added to form a dispersion containing 15 weight percent silver nanoparticles and 10 weight percent of 3-dibutylaminopropylamine. The mixture was shaken for 5 minutes to dissolve the solid and then filtered using a 0.4 micron syringe filter to give a dark brown dispersion.

The dark brown dispersion was spin coated on glass slides at 1000 rpm for 2 minutes to give brown thin films of silver nanoparticles and subsequently heated on a hot plate at 140 °C for 20 minutes to a shiny mirror-like thin film with a thickness of approximately 110 nm. The conductivity of the thin film was between 1 - 3.5 × 10⁴ S/cm and measured using a conventional four-probe technique. The dispersion of silver nanoparticles that was created by the above method was stable at room temperature for over 30 days.

### EXAMPLE 3

Silver acetate (1.67 grams, 10 mmol) and N,N-dibutylaminopropylamine (4.63 grams, 25 mmol) were dissolved in 30 mL of toluene and stirred at 40 °C for about 2 to 5 minutes until the silver acetate fully dissolved. A phenylhydrazine (0.6 grams, 5.5 mmol) solution in toluene 5 mL was added to the above solution dropwise and vigorously stirred until a dark red-brown color results. After the resulting solution was stirred at 40 °C for 5 additional minutes, stirred at 60 °C for 20 additional minutes and cooled to room temperature to remove the hexane and thus form a viscous residue. Upon the addition of 100 mL of ethanol to the residue, a precipitate was formed. After centrifuge separation and drying, black solid silver nanoparticles were obtained (yield: 1.0 grams). The silver nanoparticles were subsequently dissolved in toluene and filtered using a 0.4 micron syringe filter to form the silver nanoparticle dispersion.

The silver nanoparticle dispersion, containing 15 weight percent silver nanoparticle, was spin coated on glass slides at 1000 rpm for 2 minutes to give brown thin films of silver nanoparticles and subsequently heated on a hot plate at a temperature of 100 °C for 30 minutes to a shiny mirror-like thin film with a thickness of approximately 134 nm. The conductivity of the thin film was 1.53 × 10⁴ S/cm and measured using a conventional four-probe technique. The dispersion of silver nanoparticles that was created by the above method was stable at room temperature for over 30 days.

### COMPARATIVE EXAMPLE 1

Silver acetate (1.67 grams, 10 mmol) and 1-dodecylamine (4.63 grams, 25 mmol) were dissolved in 20 mL of toluene and stirred at 55 °C for about 2 to 5 minutes until the silver acetate fully dissolved. A phenylhydrazine (0.6 grams, 5.5 mmol) solution in 5 mL of toluene was added to the above solution drop-wise and vigorously stirred until a dark red-brown color resulted. After the resulting solution was stirred at 55 °C for 5 additional minutes, cooled to room temperature and added dropwise to mixture of acetone/methanol (150 mL/150 mL), a precipitate was formed. The precipitate (Yield: 1.33 grams) was subsequently filtered, washed briefly with acetone and methanol, dried in air and placed in a flask.

To the above flask, 7.54 grams of toluene was added to form a dispersion containing 15 weight percent silver nanoparticles. The mixture was shaken for 5 minutes to dissolve the solid and then filtered using a 0.4 micron syringe filter to give a dark brown dispersion.

The above dispersion was spin coated on glass slides at 1000 rpm for 2 minutes to give brown thin films of silver nanoparticles and subsequently heated on a hot plate at 120 °C for 20 minutes to a shiny mirror-like thin film with a thickness of approximately 110 nm. The conductivity of the thin film was between 2.3 × 10⁴ S/cm and measured using a conventional four-probe technique. The dispersion of silver nanoparticles that was created by the above method formed insoluble precipitates after three days and was thus no longer sufficiently stable.

### COMPARATIVE EXAMPLE 2

Silver acetate (1.67 grams, 10 mmol) and 1-hexadecylamine (6.04 grams, 25 mmol) were dissolved in 20 mL of toluene and stirred at 60 °C for about 2 to 5 minutes until the silver acetate fully dissolved. A phenylhydrazine (0.6 grams, 5.5 mmol) solution in toluene (5 mL) was added to the above solution drop-wise and vigorously stirred until a dark red-brown color resulted. After the resulting solution was stirred at 60 °C for 5 additional minutes, cooled to room temperature and added dropwise to mixture of acetone/methanol (150 mL/150 mL), a precipitate was formed. The precipitate (yield: 1.44 grams) was subsequently filtered, washed briefly with acetone and methanol, dried in air and placed in a flask.

To the above flask, 8.16 grams of toluene were added to form a dispersion containing 15 weight percent hexadecylamine stabilized silver nanoparticles. The mixture was shaken for 5 minutes to dissolve the solid and then filtered using a 0.4 micron syringe filter to give a dark brown dispersion.

The above dispersion was spin coated on glass slides at 1000 rpm for 2 minutes to give brown thin films of silver nanoparticles and subsequently heated on a hot plate at 140 °C for 20 minutes to a shiny mirror-like thin film with a thickness of approximately 110 nm. The conductivity of the thin film was between 2.6 × 10⁴ S/cm and measured using a conventional four-probe technique. The dispersion of silver nanoparticles that was created by the above method formed insoluble precipitates after three days and was thus no longer sufficiently stable.

It will be appreciated that various of the above-disclosed and other features and functions, or alternatives thereof, may be desirably combined into many other different systems or applications. Also, various presently unforeseen or unanticipated alternatives, modifications, variations or improvements therein may be subsequently made by those skilled in the art, and are also intended to be encompassed by the following claims.

## Claims

1. Bident amine-stabilized metal nanoparticles comprising a bident amine stabilizer associated with an external surface of the metal nanoparticle, wherein the bident amine in the bident amine stabilizer is represented by the formula: 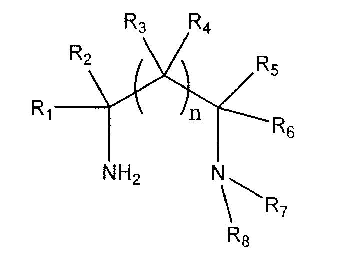 wherein n represents the number of repeating units of from 0 to 4,
wherein R₁, R₂, R₃, R₄, R₅, R₆, R₇, and R₈ are side chains independently selected from the group consisting of a hydrogen atom, a hydrocarbon group having from 1 to 15 carbon atoms, a heteroatom, and combinations thereof, and
wherein at least one of R₁, R₂, R₃, R₄, R₅, R₆, R₇, and R₈ are not a hydrogen atom.

2. The bident amine-stabilized metal nanoparticles according to claim 1, wherein the metal is selected from the group consisting of silver, gold, platinum, palladium, copper, cobalt, chromium, nickel, gold-silver composite, silver-copper composite, silver-nickel composite, gold-copper composite, gold-nickel composite, silver-gold-copper, gold-silver-palladium and combinations thereof.

3. The bident amine-stabilized metal nanoparticles according to claim 1 or 2, wherein the bident amine-stabilized metal nanoparticles are dispersed in a solvent to form a bident amine-stabilized metal nanoparticle dispersion, and/or
wherein the metal nanoparticles have a stability of at least 7 days when dispersed in a solvent selected from the group consisting of water, pentane, hexane, cyclohexane, heptane, octane, nonane, decane, undecane, dodecane, tridecane, tetradecane, toluene, xylene, mesitylene, methanol, ethanol, propanol, butanol, pentanol, hexanol, heptanol, octanol, tetrahydrofuran, chlorobenzene, dichlorobenzene, trichlorobenzene, nitrobenzene, cyanobenzene, acetonitrile, dichloromethane, N,N-dimethylformamide (DMF), and combinations thereof.

4. The bident amine-stabilized metal nanoparticles according to any preceding claim, wherein the bident amine stabilizer is comprised of a bident amine having from 4 to 17 carbon atoms.

5. The bident amine-stabilized metal nanoparticles according to any preceding claim, wherein the bident amine comprises N,N-dipropylethylenediamine, N,N-dibutylethylenediamine, N,N-dipentylethylenediamine, N,N-dihexylethylenediamine, N,N-diheptylethylenediamine, N-N-dibutylaminopropylamine, N,N-dipentylaminopropylamine, N-N-dihexylaminopropylamine, N-N-diheptylaminopropylamine, N,N-diethyl-1,4-butanediamine, N,N-dipropyl-1,4-butanediamine, N,N-dibutyl-1,4-butanediamine, N,N-dipentyl-1,4-butanediamine, N,N-dihexyl-1,4-butanediamine, N-butylethylenediamine, N-pentylethylenediamine, N-hexylethylenediamine, N-heptylethylenediamine, N-octylethylenediamine, N-nonylethylenediamine, N-decylethylenediamine, N-dodecylethylenediamine, N-undecylethylenediamine, N-tridecylethylenediamine, N-tetradecylethylenediamine, N-pentadecylethylenediamine, N-propyl-1,3-propanediamine, N-butyl-1,3-propanediamine, N-pentyl-1,3-propanediamine, N-hexyl-1,3-propanediamine, N-heptyl-1,3-propanediamine, N-octyl-1,3-propanediamine, N-nonyl-1,3-propanediamine, N-decyl-1,3-propanediamine, N-undecyl-1,3-propanediamine, N-dodecyl-1,3-propanediamine, N-tridecyl-1,3-propanediamine, N-tetradecyl-1,3-propanediamine, N-propyl-1,4-butanediamine, N-butyl-1,4-butanediamine, N-pentyl-1,4-butanediamine, N-hexyl-1,4-butanediamine, N-heptyl-1,4-butanediamine, N-octyl-1,4-butanediamine, N-nonyl-1,4-butanediamine, N-decyl-1,4-butanediamine, N-undecyl-1,4-butanediamine, N-dodecyl-1,4-butanediamine, N-tridecyl-1,4-butanediamine, or combinations thereof.

6. A method for producing a bident amine-stabilized metal nanoparticles comprising:
reducing a metal compound in the presence of a bident amine and a reducing agent to form metal nanoparticles having a bident amine stabilizer on the surface of the metal nanoparticle.

7. The method according to claim 6, wherein the metal compound is selected from a group consisting of metal oxide, metal nitrate, metal nitrite, metal carboxylate, metal acetate, metal carbonate, metal perchlorate, metal sulfate, metal chloride, metal bromide, metal iodide, metal trifluoroacetate, metal phosphate, metal trifluoroacetate, metal benzoate, metal lactate and combinations thereof.

8. The method according to claim 6 or 7, wherein the reducing agent is selected from the group consisting of a hydrazine compound, a polyol, a ketone, an aldehyde, a metal hydride, a tin (II) compound or combinations thereof,

9. The method according to claim 8, wherein the reducing agent is a hydrazine compound comprised of one or more of (1) a hydrocarbyl hydrazine represented by the following formulas:RNHNH₂, RNHNHR' OR RR'NNH₂, wherein one nitrogen atom is mono- or di-substituted with R, and the other nitrogen atom is optionally mono- or di-substituted with R, wherein R is independently selected from a hydrogen or hydrocarbon group or mixtures thereof, wherein one or both nitrogen atoms are optionally mono- or di-substituted with R' and wherein R' independently selected from a group consisting of hydrogen or hydrocarbon group or mixtures thereof, (2) a hydrazide represented by the following formulas: ROC(O)NHNHR', ROC(O)NHNH₂ or ROC(O)NHNHC(O)OR), wherein one or both nitrogen atoms are substituted by an acyl group or formula RC(O), wherein each R is independently selected from a hydrogen or hydrocarbon group or mixtures thereof, wherein one or both nitrogen atoms are optionally mono- or di-substituted with R' and wherein R' independently selected from a group consisting of hydrogen or hydrocarbon group or mixtures thereof, and (3) a carbazate represented by the following formulas: ROC(O)NHNHR', ROC(O)NHNH₂ or ROC(O)NHNHC(O)OR, wherein one or both nitrogen atoms are substituted by an ester group of formula ROC(O), wherein R is independently selected from a group consisting of hydrogen and a linear, branched, or aryl hydrocarbon, wherein one or both nitrogen atoms are optionally mono- or di-substituted with R' and wherein R' is independently selected from a group consisting of hydrogen or hydrocarbon group or mixtures thereof, preferably wherein the reducing agent is phenylhydrazine.

10. The method according to any of claims 6 to 9, wherein the method further comprises a bident amine of the bident amine stabilizer displacing a monoamine in a dispersion of monoamine-stabilized metal nanoparticles, preferably wherein the dispersion of monoamine stabilized metal nanoparticles contains a monoamine having from 8 to 17 carbon atoms, and/or wherein the monoamine comprises octylamine, nonylamine, decylamine, undecylamine, dodecylamine, tridecylamine, tetradecylamine, hexadecylamine, heptadecylamine or combinations thereof.

11. A method for producing conductive features on a substrate comprising:
providing a solution of dispersed metal nanoparticles,
adding a bident amine to the solution of dispersed metal nanoparticles to form a bident amine-stabilized metal nanoparticle dispersion,
depositing the bident amine-stabilized metal nanoparticle dispersion onto a substrate, and
heating the printed substrate to form conductive features on the surface of the substrate.

12. The method according to claim 11, wherein the substrate is heated to a temperature below 150 °C.

13. The method according to claim 11 or 12, wherein the solvent for the bident amine-stabilized metal nanoparticle dispersion is selected from the group consisting of water, pentane, hexane, cyclohexane, heptane, octane, nonane, decane, undecane, dodecane, tridecane, tetradecane, toluene, xylene, mesitylene, methanol, ethanol, propanol, butanol, pentanol, hexanol, heptanol, octanol, tetrahydrofuran, chlorobenzene, dichlorobenzene, trichlorobenzene, nitrobenzene, cyanobenzene, acetonitrile, dichloromethane, N,N-dimethylformamide (DMF), and combinations thereof.

14. The method according to any of claims 11 to 13, wherein the depositing is selected from the group consisting of spin coating, blade coating, rod coating, dip coating, lithography or offset printing, gravure, flexography, screen printing, stencil printing, inkjet printing, and stamping.

15. The method according to claim 6 or 11, further comprising the features of any of claims 1, 2 or 5.
